## Europäisches Patentamt

## European Patent Office

## Office européen des brevets

(19)

(11) Veröffentlichungsnummer: **0 200 049 B1**

(12) **EUROPÄISCHE PATENTSCHRIFT**

(45) Veröffentlichungstag der Patentschrift:
24.01.90

(51) Int. Cl.⁴: **G01N 24/08**, A61B 5/05

(21) Anmeldenummer: **86104943.5**

(22) Anmeldetag: **10.04.86**

(54) Verfahren und Vorrichtung zur Zusammensetzung eines MR-Bildes aus atemgesteuert aufgenommenen Bilddaten.

(30) Priorität: **22.04.85 DE 3514542**

(43) Veröffentlichungstag der Anmeldung:
**10.12.86 Patentblatt 86/45**

(45) Bekanntmachung des Hinweises auf die Patenterteilung:
**24.01.90 Patentblatt 90/4**

(84) Benannte Vertragsstaaten:
**DE FR GB NL**

(56) Entgegenhaltungen:
**EP-A- 0 117 725**
**EP-A- 0 121 312**
**EP-A- 0 132 785**
**EP-A- 0 132 975**

**ELECTROMEDICA, Band 52, Nr. 1, 1984, Seiten 28-37; Erlangen, DE; A. GANSSEN: "Bericht über die Tagungen der Society of Magnetic Resonance in Medicine vom 16. bis 19. 8. 1983 in San Francisco und der International Society of Magnetic Resonance vom 22. bis 26. 8. 1983 in Chicago" 000**

**Die Akte enthält technische Angaben, die nach dem Eingang der Anmeldung eingereicht wurden und die nicht in dieser Patentschrift enthalten sind.**

(73) Patentinhaber: **Siemens Aktiengesellschaft, Wittelsbacherplatz 2, D-8000 München 2(DE)**

(72) Erfinder: **Schneider, Siegfried, Dr., Kulmbacher Strasse 33, D-8520 Erlangen(DE)**
Erfinder: **Wirth, Axel, Siemensstrasse 39, D-8500 Nürnberg(DE)**
Erfinder: **Schajor, Wilfried, Dr., Hofmannstrasse 9, D-8520 Erlangen(DE)**
Erfinder: **Reichenberger, Helmut, Dr., Begonienstrasse 28, D-8521 Eckental(DE)**

## Beschreibung

Die Erfindung betrifft ein Verfahren zur Zusammensetzung eines MR-Bildes aufgrund einer aus einzelnen Fourier-Zeilen zusammengesetzten Meßmatrix mit atemgesteuerter Aufnahme der Spinechos, die von einem MR-Gerät empfangen werden, bei welchem ein Atemzyklus auf die Erfüllung eines Kriteriums bezüglich eines vorgegebenen Referenzwertes untersucht wird und bei welchem während jedes Atemzyklus eine Mehrzahl von Scans aufgenommen wird, wobei jeder Scan durch die Anregung der Kernspins und eine nachfolgende Abtastung des ausgelesenen Kernresonanzsignals definiert ist. Die Erfindung betrifft weiterhin eine Vorrichtung zur Durchführung des Verfahrens.

Es ist bekannt, daß man insbesondere die Wasserstoffkernspins eines Untersuchungsobjektes aus einer Vorzugsrichtung, die durch ein ·Magnet-Grundfeld vorgegeben wird, durch einen hochfrequenten Anregungsimpuls auslenken kann und daß sich diese Spins erst nach einer gewissen Zeit nach dem Ende des Anregungsimpulses wieder in die Vorzugsrichtung einstellen. Während dieser Zeit präzedieren die Spins mit einer Frequenz, die von der Stärke des Magnet-Grundfeldes abhängt. Die Präzessionsbewegung kann mit einer HF-Antenne und entsprechenden Empfängerschaltungen detektiert werden. Überlagert man dem homogenen Magnet-Grundfeld einen ersten Feldgradienten, so daß die Magnetfeldverteilung räumlich variiert, so ist eine Ortung der Spins in einer ersten Raumrichtung, nämlich der Gradientenrichtung, über die jeweils gemessene Frequenz möglich.

Es ist auch bekannt, daß man durch kurzzeitiges Anlegen eines zum ersten Gradienten orthogonalen zweiten Gradienten variabler Amplitude oder Zeitdauer eine Ortskodierung in einer zweiten Raumachse vornehmen kann, bevor die Signale im ersten Gradienten ausgelesen werden, und daß man auf diese Weise Schichtbilder eines Untersuchungsobjektes anfertigen kann. Die Anregung in einer Schicht des Untersuchungsobjektes erfolgt dabei dadurch, daß das Magnet-Grundfeld durch einen weiteren dritten Feldgradienten senkrecht zum ersten und zweiten Gradienten so beeinflußt wird, daß nur in dieser Schicht eine Anregung der Spins erfolgt. Dies ist möglich, weil die Anregung nur mit einer Frequenz erfolgt, die dem Magnetfeld in der gewünschten Schicht streng zugeordnet ist. Dieses Verfahren ist z.B. in der DE-OS 2 611 497 beschrieben.

Da die in der MR-Technik benötige Aufnahmezeit· relativ lang ist, entstehen Bildstörungen durch die Bewegung von Herz und Lunge bei Aufnahmen in diesem Bereich.

Man ist daher dazu übergegangen, auch bei MR-Aufnahmen herz- und atmungsgesteuerte Bilddatenerfassung vorzusehen.

Aus der EP-A 117 725 ist eine atmungsgesteuerte Bilddatenerfassung bekannt, wobei der Verlauf der Atemkurve durch die Signalamplitude des Kernspinresonanzsignals erfaßt wird. Wenn die Signalamplitude innerhalb einer gewissen Bandbreite liegt, werden die Meßsignale zur Bildung von Fourier-Zeilen einer Meßmatrix erfaßt. In einer speziellen Ausführungsform wird auch die Herzbewegung mit berücksichtigt, indem eine Meßwerterfassung nur dann stattfindet, wenn sie sowohl zur Atmung als auch zum EKG synchron ist.

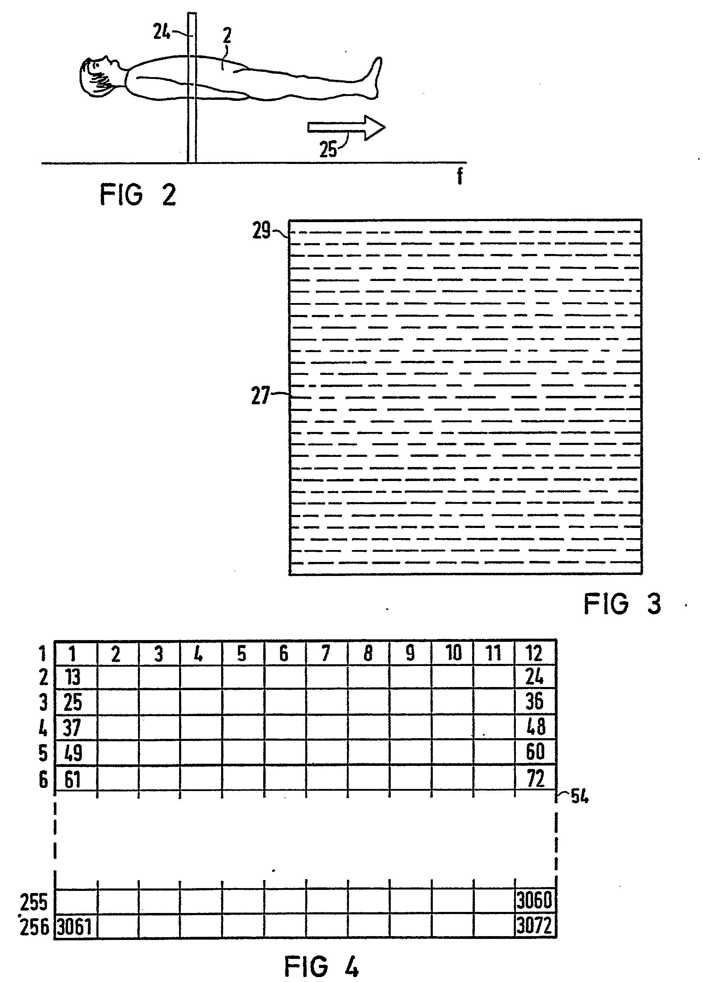

Ein Verfahren der eingangs genannten Art ist aus der Veröffentlichung "Magnetic Resonance Imaging with Respiratory Gating" von Richard L. Ehman et al, AJR 143, Dez. 1984, S. 1175–1182, vorbekannt. Aus der Figur 3, unterer Teil, und deren Beschreibung auf Seite 1176 ist ein Verfahren zu entnehmen, bei welchem das Hochfrequenzsignal in regelmäßigen Abständen ausgestrahlt wird; entsprechend diesen Abständen fallen auch regelmäßig Spinechos an. Jedoch werden hier nicht alle Spinechosignale zur Bildzusammensetzung herangezogen, sondern nur diejenigen 4 oder 5, die während eines Intervalls gewonnen werden, welches aus der Atemkurve abgeleitet ist. Es werden in dieser Literaturstelle keine Angaben darüber gemacht, ob alle der so gewonnenen Spinechosignale der 4 oder 5 Scans zur Bildzusammensetzung genutzt werden oder nur ein Teil davon.

Die Erfindung beruht auf der Erkenntnis, daß die Auswahl dieser 4 oder 5 Scans während der Bilddatenerfassung den Nachteil hat, daß eine im Allgemeinen häufig vorkommende Änderung der Atmung nicht berücksichtigt werden kann. Daher kann man im Verlauf der Bilddatenerfassung nur bedingt Scans immer in der gleichen Bewegungsphase aufnehmen, wie es für ein störungsfreies MR-Bild wünschenswert ist.

Aufgabe vorliegender Erfindung ist es, ein Verfahren und eine Vorrichtung der eingangs genannten Art so auszubilden, daß die Bildqualität verbessert wird.

Diese Aufgabe wird bezüglich des Verfahrens dadurch gelöst, daß entsprechend der Anzahl der atemgesteuert aufgenommenen Fourierzeilen der Phasenkodiergradient des MR-Gerätes höchstens einmal pro Atemzyklus weitergeschaltet wird, daß die zu jedem Scan aufgenommenen Spinechos in einem ersten Speicher gespeichert werden, daß die Amplitude der Atembewegung zum jeweiligen Scanzeitpunkt in einem zweiten Speicher abgespeichert wird, daß ein Vergleich sämtlicher gespeicherter Amplituden der Atembewegung mit dem vorgegebenen Referenzwert durchgeführt wird, und daß zur Zusammensetzung des MR-Bildes bei gleicher Amplitude des Phasenkodiergradienten nur derjenige Scan verwendet wird, bei dem die zugehörige Amplitude der Atembewegung das vorgegebene Kriterium bezüglich des Referenzwertes erfüllt.

Bei einer Vorrichtung der eingangs genannten Art wird diese Aufgabe erfindungsgemäß gelöst durch einen ersten Speicher, der zur Abspeicherung der Werte der gemessenen Spinechos vorgesehen ist, durch einen zweiten Speicher, der zur Abspeicherung der Amplitude der Atembewegung zum zugehörigen Scanzeitpunkt vorgesehen ist, durch einen Vergleicher, in welchem die Amplituden der Atembewegung zu den Scanzeitpunkten mit einem vorgegebenen Referenzwert vergleichbar sind, und durch ein Steuergerät, welches nur diejenigen Spinechosignale eines einzigen Scans pro Amplitudenstellung des Phasenkodiergradienten zur MR-Bilddarstellung freigibt, bei denen die zugeordnete Amplitude der Atembewegung ein in dem Vergleicher einstellbares Kriterium bezüglich des Referenzwertes erfüllt.

Dieses Verfahren bietet den Vorteil, daß zur MR-Bildzusammensetzung nur diejenigen Spinechos ausgewählt werden, die jeweils zu dem "besten Scan" eines Atemzyklus gehören. Unter dem "besten Scan" wird dabei derjenige Scan angesehen, der das vorgegebene Kriterium bezüglich der Amplitude (oder einer anderen geeigneten Charakteristischen Größe wie z. b. der Steigung) der Atembewegung am besten erfüllt. Dieses Kriterium kann z. B. der geringste Abstand der Amplitude der Atembewegung zu dem vorgegebenen Referenzwert sein. Der vorgegbene Referenzwert kann somit auch ein Referenzwert für die Steigung der Atembewegung sein. Eine Steigung Null würde z. B. bedeuten, daß man denjenigen Scan auswählt, der zu einem Zeitpunkt aufgenommen wurde, der dem Minimum oder dem Maximum der Atembewegung am nächsten lag. Es lassen sich auch mehrere Kriterien verknüpfen, so z. B. daß zusätzlich zum geringsten Abstand der Amplitude der Atembewegung die Steigung der Atemkurve in diesem Punkt herangezogen wird. So läßt sich erreichen, daß nur solche Scans zur MR-Bilddarstellung herangezogen werden, die innerhalb der Ausatmungsphase oder innerhalb der Einatmungsphase angefallen sind.

Eine besonders vorteilhafte Ausführungsform des Verfahrens zeichnet sich dadurch aus, daß der Referenzwert der Wert ist, bei welchem die Standardabweichung einer vorgegebenen Anzahl von mittleren Fourierzeilen am kleinsten ist. Anhand von mittleren Fourierzeilen, die die Bildqualität am stärksten prägen, wird ein statistisch optimaler Referenzwert ermittelt. Dieser Refernzwert wird dann auch als Kriterium für die Scans von den anderen Fourierzeilen, die atemgesteuert aufgenommen werden, herangezogen.

Als Vorteil bei der Vorrichtung zur Durchführung des Verfahrens erweist sich die Verwendung des ersten und des zweiten Speichers. Dadurch, daß sämtliche Scans mit ihren zugehörigen Atemamplituden abgespeichert werden, können im Nachhinein interessierende MR-Bilder zusammengesetzt werden. Es besteht beispielsweise die Möglichkeit, zwei MR-Bilder aus verschiedenen Atemphasen, z. B. dem ein- und dem ausgeatmeten Zustand, zu subtrahieren. So entsteht ein Differenzbild. Man kann auch mehrere Bilder in verschiedenen Atemphasen erzeugen. Diese Einzelbilder können z. B. zur dynamischen Darstellung der Atembewegung in Form eines Filmes verwendet werden. Weiterhin besteht die Möglichkeit, künstlich Artefakte zu simulieren, um deren Auswirkungen auf die Bildqualität zu erforschen. So kann bei einer Anzahl von Fourierzeilen, z. B. bei der 95. bis 100. Zeile ein vom Referenzwert stark abweichender Scan zur Bildzusammensetzung verwendet werden, und daraus können dann Rückschlüsse gezogen werden, wie sich ein Artefakt zum Zeitpunkt der Aufnahme dieser Fourierzeilen auswirkt.

Weitere Vorteile und Ausgestaltungen der Erfindung ergeben sich aus der Beschreibung der Figuren in Verbindung mit den Unteransprüchen. Es zeigen:

Fig. 1 eine Darstellung eines MR-Gerätes nach der Erfindung,

Fig. 2 bis 4 Darstellungen zur Erläuterung der Wirkungsweise des MR-Gerätes gemäß Fig. 1 und des erfindungsgemäßen Verfahrens, und

Fig. 5 einen Signalablauf mit EKG- und Atemtriggersignal.

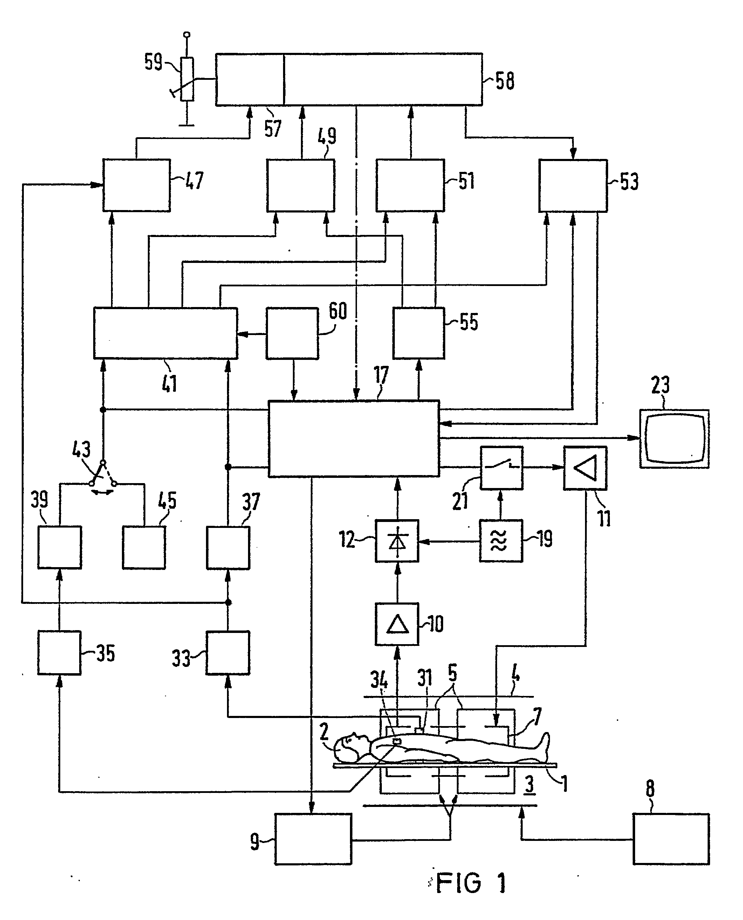

In Figur 1 ist eine Auflage 1 dargestellt, auf der ein Patient 2 liegt, von dem mit Hilfe magnetischer Kernresonanz MR-Bilder erzeugt werden sollen. Hierzu ist ein Spulensystem 3 mit einer Spule 4 zur Erzeugung eines homogenen Magnet-Grundfeldes, Gradientenspulen 5 zur Variierung dieses Magnetgrundfeldes sowie mit einer Anregungs- und Meßspule 7 vorhanden. Die Spule 4 ist an einer Magnet-Stromversorgung 8, die Gradientenspulen 5 sind an einer Gradienten-Stromversorgung 9, die Anregungs- und Meßspule 7 ist an einem Vorverstärker 10 und über entsprechende Koppelelemente an einen Sendeverstärker 11 angeschlossen. Der Vorverstärker 10 führt das Meßsignal der Spinechos über einen phasenempfindlichen Gleichrichter 12 einem Prozeßrechner 17 zu, der den gesamten Meßvorgang steuert. Zur Erzeugung eines Anregungsimpulses dient ein Hochfrequenzoszillator 19. Er ist über einen Modulator 21 an den Sendeverstärker 11 anschaltbar. Die Wiedergabe der aus den Meßsignalen rekonstruierten MR-Bilder erfolgt auf einem Monitor 23. Zur Erzeugung eines Schichtbildes von dem im Spulensystem 3 gelagerten Patienten 2 werden zunächst die Spins in der gewünschten Schicht angeregt.

Figur 2 zeigt, daß die jeweils angeregte Schicht 24 im Patienten 2 von der Ortsabhängigkeit der Flußdichte und damit der Kernresonanzfrequenz bestimmt wird. Der Feldgradient für das Magnet-Grundfeld ist in der Figur 2 schematisch dargestellt und mit 25 bezeichnet. Die Resonanzfrequenz ist mit f bezeichnet. Es erfolgt dabei nur eine Anregung der Spins im dargestellten Bereich des Patienten 2.

Nach der Anregung erfolgt die Kodierung der Spins in der eingangs als zweite Raumachse bezeichneten Richtung eines kurzzeitigen Gradienten in dieser zweiten Raumrichtung. Dieser Gradient wird im folgenden Phasenkodiergradient genannt. Anschließend wird das Kernresonanzsignal in dem die erste Raumdimension definierenden sog. Auslesegradienten abgetastet. Dieser Vorgang wird z. B. mit schrittweise von positiv nach negativ verändertem Phasenkodiergradienten wiederholt. Die zu einer bestimmten Phasenkodiergradienten-Amplitude ausgelesenen Kernresonanzsignale kann man als Fourier-Projektion bezeichnen.

Die den aufeinanderfolgenden Fourier-Projektionen entsprechenden Meßsignale entsprechen parallelen Fourierzeilen der in der Figur 3 dargestellten Meßmatrix 29. In der Praxis können beispielsweise für eine vollständige Meßmatrix 29 insgesamt 256 Fourierzeilen vorgesehen werden, wobei die Fou-

rier-0-Zeile 27, die zum Phasenkodiergradienten der Amplitude 0 gehört, in der Mitte der Meßmatrix 29 gemäß Fig. 3 liegt. Durch zweidimensionale Fourier-Transformation nach Zeilen und Spalten kann aus den Meßsignalen der einzelnen Fourierzeilen ein Bild der untersuchten Schicht berechnet werden.

Zur Erfassung der Atembewegung ist nach Fig. 1 als Sensor ein Leitgummigürtel 31 um den Patienten 2 gelegt. Die elektrische Widerstandsänderung des Leitgummigürtels 31 entspricht der Umfangsänderung des Abdomens und ist so ein Maß für die Atembewegung. Vorteile dieses Sensors sind die gute Zuordnung des Meßsignals zur Zwerchfellbewegung, die Möglichkeit der Absolutmessung der Atemamplitude, die Verwendung nichtmagnetischer Werkstoffe und die einfache und praktikable Applikation. Vom Leitgummigürtel 31 führt eine Leitung zu einer Aufbereitungsstufe 33, in welcher die Widerstandsänderungen des Leitgummis in eine Atemsignalkurve umgesetzt wird. Zusätzlich sind am Brustkorb des Patienten in konventioneller Weise EKG-Elektroden 34 angebracht, die zu einer EKG-Signalverarbeitungsstufe 35 führen, an deren Ausgang das EKG-Signal abgegeben wird. Vom Ausgang der Aufbereitungsstufe 33 führt eine Leitung zu einer Atemtriggereinheit 37. Auch ist der Ausgang der EKG-Signalverarbeitungsstufe 35 zur Weiterleitung des EKG-Signals an eine EKG-Triggereinheit 39 geführt. In den Triggereinheiten 37, 39 werden aus den Bewegungskurven der Atmung bzw. des Herzens Steuersignale gebildet, welche immer in der gleichen Bewegungsphase des Bewegungszyklus abgegeben werden.

Das Steuersignal, welches am Ausgang der Atemtriggereinheit 37 zur Verfügung steht, wird an den Prozeßrechner 17 geführt, woraufhin dieser den Phasenkodiergradienten pro Bewegungszyklus einmal weiterschaltet. Bei extrem hoher Atemfrequenz, wie sie z. B. bei Kindern anzutreffen ist, ist es sinnvoll den Phasenkodiergradienten erst nach mehreren Atemzügen oder aber nach einer vorgegebenen Anzahl aufgenommener Scans weiterzuschalten. Wesentlich ist dann, daß zwischen zwei Steuersignalen die aus der Atembewegung abgeleitet werden und die Weiterschaltung des Phasenkodiergradienten bewirken wenigstens ein voller Atemzug liegt. Die Auslösung dieses Steuersignals braucht nicht mehr an eine Bewegungsphase der Atmung gebunden zu sein. Es kann ein Zeitraum von z. B. 20s vorgewählt werden, in welchem mit Sicherheit ein voller Atemzug des Patienten 2 erfolgt ist. Danach wird die nächste Fourierzeile der Meßmatrix 29 gemessen. Weiterhin wird dieses Steuersignal vom Ausgang der Atemtriggereinheit 37 zu einem Adreßzähler 41 geführt. Das Steuersignal, welches am Ausgang der EKG-Triggereinheit 39 anliegt, wird ebenfalls zu dem Adreßzähler 41 weitergeleitet. Für den Fall, daß nicht-EKG-getriggerte MR-Bilder aufgenommen werden sollen, ist ein Umschalter 43 vorgesehen, mit welchem wahlweise anstelle der EKG-Triggereinheit 39 eine Scan-Triggereinheit 45 eingeschaltet werden kann. Die Scan-Triggereinheit 45 liefert dabei Steuersignale in einem fest vorgebbaren zeitlichen Abstand. Außer zu dem Adreßzähler 41 werden die Steuersignale, die am Ausgang der EKG-Triggereinheit 39 oder je nach Stellung des Umschalters 43 am Ausgang der Scan-Triggereinheit 45 zur Verfügung stehen, auch an den Prozeßrechner 17 geleitet. Dieser löst nach Eingang dieses Steuersignals jeweils einen Scan aus.

Vom Adreßzähler 41 führen Signalleitungen zu einem Atemsignalspeicher 47, einem Atemtriggerzeitpunktspeicher 49, einem Scantriggerzeitpunktspeicher 51 und einem MR-Rohdatenspeicher 53. Unter MR-Rohdaten werden dabei die bei einem Scan gemessenen und vom Prozeßrechner 17 aufbereiteten Spinechosignale verstanden. Der Atemsignalspeicher 47, der Scantriggerzeitpunktspeicher 51 und der MR-Rohdatenspeicher 53 sind jeweils bevorzugt wie der Speicher 54 in Figur 4 aufgebaut, wie später erläutert wird. Der Adreßzähler 41 adressiert die Speicher 47 bis 53 entsprechend den eingehenden Steuersignalen von der Atemtriggereinheit 37 einerseits und der EKG-Triggereinheit 39 oder der Scan-Triggereinheit 45 andererseits.

Bei jedem Steuersignalimpuls von der EKG-Triggereinheit 39 bzw. der Scantriggereinheit 45 erhöht sich die Speicheradresse jeweils um 1, z. B. von 7 auf 8. Wird jedoch ein Steuersignalimpuls von der Atemtriggereinheit 37 an den Adreßzähler 41 abgegeben, so springt der Adreßzähler 41 auf die kleinste Adresse der nächsten Zeile, z. B. von 8 auf 13, da eine Zeile aus 12 Spalten besteht. Von dort wird beim Eintreffen eines Steuersignalimpulses von der EKG-Triggereinheit 39 jeweils wieder eine Adresse weitergeschaltet. Anhand der Figur 4 wird dieser Vorgang später noch einmal näher erläutert.

Die so adressierten Speicher 47 bis 53 lesen jeweils bei Vorliegen einer neuen Speicheradresse den an ihrem Eingang befindlichen Signalwert in den zugehörigen Speicherplatz ein. Der am Eingang anliegende Signalwert ist beim Atemsignalspeicher 47 die Amplitude der Atembewegung. Diese wird am Ausgang der Aufbereitungsstufe 33 abgegriffen. Beim Atemtriggerzeitpunktspeicher 49 ist der Signalwert der Zeitstand einer Uhr 55, welche bei Beginn der Untersuchung des Patienten 2 gestartet wird. Die Uhr 55 wird also kurz vor dem ersten Scan, der überhaupt bei der Untersuchung anfällt, in Gang gesetzt. Der Scantriggerzeitpunktspeicher 51 ist ebenfalls an die Uhr 55 angeschlossen. In die Zeitpunktspeicher 49, 51 wird also jeweils die Zeit eingespeichert, welche vom Beginn der Untersuchung bis zum Auftreten des Atemtrigger- und EKG-Trigger- bzw. Scan-Triggersignals verstrichen ist. In dem MR-Rohdatenspeicher 53 werden die vom Prozeßrechner 17 aufbereiteten Spinechosignale auf dem jeweils adressierten Speicherplatz eingeschrieben.

Der Atemsignalspeicher 47 ist ausgangsseitig mit einem Vergleicher 57 verbunden. An dem Vergleicher 57 befindet sich ein Einstellglied 59 zur Vorgabe eines Referenzwertes R der Atemamplitude. Ist die Untersuchung des Patienten 2 abgeschlossen, so werden nacheinander die Inhalte der Speicherplätze einer jeden Zeile des Atemsignalspeichers 47 mit dem Referenzwert R verglichen. Nur derjenige Speicherplatz einer Fourierzeile, dessen Signalwert (Atemamplitude) dem Refernzwert R am nächsten kommt, wird - gesteuert über ein Steuergerät 58 - an den Adreßeingang des MR-Rohdatenspeichers 53 gelegt. Die zugehörigen Spinechosignale des so ermittelten Speicherplatzes werden in den Prozeßrechner 17 eingelesen und zur MR-Bildzusammensetzung verwendet. Dieser Vorgang wiederholt sich Zeile für Zeile, bis die letzte Fourierzeile mit der Nummer 256 verarbeitet ist.

Anstelle des Einstellgliedes 59 zur Vorgabe des Referenzwertes R kann dieser Referenzwert R auch durch eine (nicht gezeigte) Schaltung ermittelt werden, welche die Standardabweichung der Atemamplituden ermittelt. Diese ist der Wert, bei dem bei einer vorgegebenen Anzahl von mittleren Fourierzeilen die mittlere Abweichung am kleinsten ist. Für dieses Verfahren der Bestimmung der Standardabweichung können z. B. die sieben mittleren Fourierzeilen, also de Zeilen 125 bis 131, herangezogen werden.

Am Ende einer Untersuchung sind im Atemsignalspeicher 47 sämtliche Atemamplituden, die zu den Scanzeitpunkten angefallen sind, abgespeichert. Im MR-Rohdatenspeicher 53 sind auf den gleichen Speicherplätzen die zugehörigen Spinechosignale eingespeichert. Der Referenzwert R kann im Nachhinein gewählt oder auch geändert werden, um MR-Bilder zu unterschiedlichen Bewegungsphasen der Atembewegung zu erhalten. Diese MR-Bilder können einen unterschiedlichen Aussagegehalt haben.

Zusätzlich zum Atemsignalspeicher 47 kann ein gleichartig aufgebauter weiterer (nicht gezeigter) Speicher vorgesehen werden, in welchem die Steigung der Atemkurve zum jeweiligen Scanzeitpunkt abgespeichert ist. Der Vergleicher 57 ermittelt dann nicht nur nach dem Kriterium "geringste Differenz" zwischen Referenzwert R und Atemamplitude, sondern berücksichtigt auch noch, ob z. B. das Vorzeichen dieser Steigung positiv oder negativ ist. Auch ist es denkbar, allein die Steigung zur Auswahl derjenigen Spinechosignale, aus welche das MR-Bild zusammengesetzt werden soll, zu wählen. So z. B. kann bei Vorgabe der Steigung Null und unter Berücksichtigung der Amplitude jeweils ein MR-Bild zum einatmungstiefsten und einatmungshöchsten Zustand erstellt werden.

Das Verfahren wird zweckmäßigerweise nicht bei allen 256 Fourierzeilen angewendet, sondern bevorzugt in einem mittleren Bereich, der z. B. von der 108. bis 148. Fourierzeile reicht. Dieser mittlere Bereich wird in einem Zeilenbereichsvorwähler 60 eingestellt. Dadurch kann die Kapazität der Speicher 47 bis 53 verhältnismäßig klein gehalten werden.

Es ist vorteilhaft, das Atemtriggersignal beim Wechsel von der Ein- in die Ausatmung zu erzeugen. Da beim Anfall des Steuersignals am Ausgang der Atemtriggereinheit 37 der Phasenkodiergradient weitergeschaltet wird, werden während eines Atemzuges die Spinechosignale mit konstantem Phasenkodiergradienten gemessen und abgespeichert. Mit Hilfe des Vergleichers 57 wird aus den so gesammelten Rohdaten anhand der Atemsignale aus jedem Atemzug ein geeigneter Scan also geeignete Spinechosignale ausgewählt.

In Figur 4 ist der Aufbau des Speichers 54, der als Speicher 47, 51, 53 verwendet werden kann dargestellt. Der Speicher 54 besteht aus einer Matrix von Speicherplätzen, die entsprechend der Anzahl an Fourierzeilen 256 Zeilen 1, 2,... 256 umfaßt. Jede Zeile besitzt z. B. 12 Speicherplätze, auf welchen - je nach Speicher 47, 51, 53 - die Atemamplitude, der EKG- oder Scantriggerzeitpunkt bzw. die Rohdaten eingespeichert werden.

Der Speicher 49 besteht aus 256 Zeilen und nur einer Spalte. In diesem Speicher wird der Atemtriggerzeitpunkt eingespeichert.

Der Speicher 54, also jeder der Speicher 47 bis 53, wird vom Adreßzähler 41 adressiert. Der Adreßzähler 41 adressiert dabei die Speicherplätze 1, 2, 3 bis 3072 entsprechend den anliegenden Steuersignalen der Atemtriggereinheit 37 sowie der EKG-Triggereinheit 39 bzw. der Scan-Triggereinheit 45. Dabei wird bei Anliegen eines EKG-Triggersteuerimpulses der Speicherplatz innerhalb einer Zeile jeweils um 1 erhört, z. B. in der Zeile 1 von 7 auf 8. Da innerhalb eines Atemzyklus in der Regel nicht mehr als neun bis zehn Herzschläge auftreten, werden die hinteren Speicherplätze einer jeden Zeile, z. B. die Speicherplätze 23 und 24 der Zeile 2, in der Regel nicht adressiert werden. Daher reichen 12 Speicherplätze pro Zeile. Sollte dennoch eine besonders hohe Herzfrequenz vorliegen, so daß mehr als zwölf Herzschläge pro Atemzyklus vorliegen, werden die die Zahl 12 übersteigenden Scans pro Atemzyklus nicht abgespeichert. Im Normalfall wird also beispielsweise bei Beginn der Untersuchung bis zum Speicherplatz 6 adressiert. Dann erfolgt ein Atemtriggersteuerimpuls, woraufhin der Adreßzähler 41 zum ersten Speicherplatz der nächsten Zeile umschaltet, also zum Speicherplatz 13 der 2. Zeile. Mit jedem EKG-Triggersteuerimpuls wird dann innerhalb dieser 2. Zeile der Speicherplatz um 1 weiteradressiert. Bei angenommenen sieben Herzschlägen während des zweiten Atemzyklus werden also nacheinander die Speicherplätze 13 bis 19 adressiert. Dann liege ein weiterer Atemtriggersteuerimpuls an, und der Adreßzähler 41 schaltet um auf die erste Adresse der nächsten Zeile, also auf den Speicherplatz 25. Dieser Vorgang wiederholt sich, bis alle 256 Fourierzeilen aufgenommen sind.

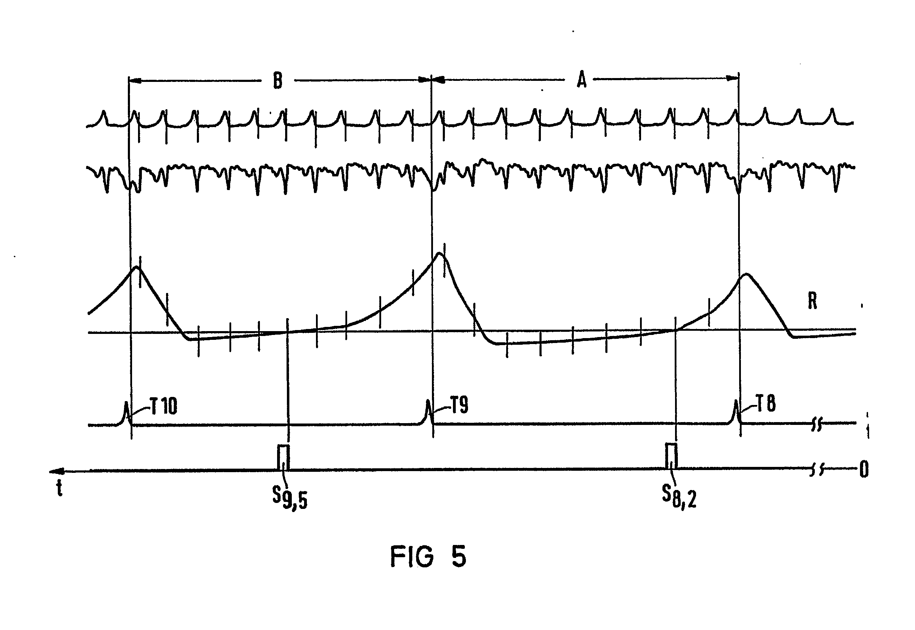

In Figur 5 ist der Ablauf verschiedener Signale nach dem hier beschriebenen Verfahren in Abhängigkeit von der Zeit t dargestellt. Bei der Darstellung verläuft die Zeitachse t von rechts nach links.

In der zweiten Zeile ist das EKG-Steuersignal dargestellt, das am Ausgang der EKG-Signalverarbeitungsstufe 35 abgegriffen wird. Dieses wird in ein EKG-Triggersignal umgesetzt, welches in der ersten Zeile von Figur 5 veranschaulicht ist. Die kurzen senkrechten Striche in dem EKG-Triggersignal markieren die Zeitpunkte, an denen die einzelnen Scans ausgelöst werden. Im dritten Diagramm ist der zeitliche Verlauf des Atemsignals dargestellt, das am Ausgang der Aufbereitungsstufe 33 anliegt. Zusätzlich ist der Referenzwert R eingezeichnet. Es ist ersichtlich, daß aus diesem Signal die Atemtriggereinheit 37 ein Signal ableitet, das im vierten Diagramm aufgezeichnet ist. Die zwischen den Abständen A und B eingezeichneten durchgehenden senkrechten Linien markieren dabei den jeweiligen Atemtrigger-Zeitpunkt. Im Atemtriggersignal sind verschiedene Triggerimpulse T8, T9 und T10 ersichtlich, die zur Triggerung des Prozeßrechners 17 einerseits und des Adreßzählers 41 andererseits dienen. Im Zeitraum A befinden sich insgesamt neun Herzschläge, die am Atemsignal im dritten Diagramm durch kurze vertikale Striche eingezeichnet sind. Im Zeitraum B befinden sich dagegen zehn Herzschläge. Jeder Zeitpunkt eines solchen Herzschlages entspricht, wie oben dargelegt, einem Scan. Sowohl im Zeitraum A als auch im Zeitraum B wird das Atemsignal mit dem Referenzwert R verglichen, und zwar zu den einzelnen Scanzeitpunkten, und der kleinste Abstand wird ermittelt. Im Zeitraum A ist der kleinste Abstand beim zweiten Herzschlag gegeben, und im Zeitraum B liegt der kleinste Abstand beim fünften Herzschlag vor. Die entsprechenden Scans, die mit $S_{8,2}$ bzw. $S_{9,5}$ bezeichnet sind, werden zur Bildzusammensetzung herangezogen. Die weiteren Scans innerhalb der Zeiträume A und B werden nicht berücksichtigt.

Mit Hilfe des Atemtriggerzeitpunktspeichers 49 und des Scantriggerzeitpunktspeichers 51 kann ermittelt werden, ob ein Scantriggerimpuls gleichzeitig mit dem Atemtriggerimpuls angefallen ist. Ist dieses der Fall, so wird der Scan nicht zum Scantriggerzeitpunkt ausgelöst, sondern erst dann, wenn die Konsequenzen aus dem Auftreten des Atemtriggersignals vollzogen sind. So z. B. muß erst der Phasenkodiergradient weitergeschaltet werden und der Adreßzähler 41 zur nächsten Zeile springen. Dadurch wird der Scan nicht mehr zur gewünschten Phasenlage des Herzens ausgelöst, sondern später. Seine zugehörigen Spinechosignale sind unbrauchbar und werden nicht abgespeichert.

Bezugszeichenliste

1 Auflage
2 Patient
3 Spulensystem
4 Spule
5 Gradientenspule
7 Meßspule-Anregungsspule
8 Magnet-Stromversorgung
9 Gradienten-Stromversorgung
10 Vorverstärker
11 Sendeverstärker
12 phasenempfindlicher Gleichrichter
13 erster Speicher
15 Vergleicher
17 Prozeßrechner
19 Hochfrequenzoszillator
21 Modulator
23 Monitor
24 Schicht
25 Feldgradient
27 Fourier-Nullzeile
29 Meßmatrix
31 Leitgummigürtel
33 Aufbereitungsstufe
34 EKG-Elektroden

35 EKG-Signalverarbeitungsstufe
37 Atemtriggereinheit
39 EKG-Triggereinheiten
41 Adreßzähler
43 Umschalter
45 Scantriggereinheit
47 Atemsignalspeicher
49 Atemtriggerzeitpunktspeicher
51 Scantriggerzeitpunktspeicher
53 MR-Rohdatenspeicher
54 Speicher
55 Uhr
57 Vergleicher
58 Steuergerät
59 Einstellglied
60 Zeilenbereichsvorwähler

**Patentansprüche**

1. Verfahren zur Zusammensetzung eines MR-Bildes aufgrund einer aus einzelnen Fourier-Zeilen zusammengesetzten Meßmatrix mit atemgesteuerter Aufnahme der Spinechos, die von einem MR-Gerät empfangen werden, bei welchem ein Atemzyklus auf die Erfüllung eines Kriteriums bezüglich eines vorgegebenen Referenzwertes untersucht wird und bei welchem während jedes Atemzyklus eine Mehrzahl von Scans aufgenommen wird, wobei jeder Scan durch die Anregung der Kernspins und eine nachfolgende Abtastung des ausgelesenen Kernresonanzsignals definiert ist, dadurch gekennzeichnet, daß entsprechend der Anzahl der atemgesteuert aufgenommenen Fourier-Zeilen der Phasenkodiergradient des MR-Gerätes höchstens einmal pro Atemzyklus weitergeschaltet wird, daß die zu jedem Scan aufgenommenen Spinechos in einem ersten Speicher gespeichert werden, daß die Amplitude der Atembewegung zum jeweiligen Scanzeitpunkt in einem zweiten Speicher abgespeichert wird, daß ein Vergleich sämtlicher gespeicherter Amplituden der Atembewegung mit dem vorgegebenen Referenzwert durchgeführt wird, und daß zur Zusammensetzung des MR-Bildes bei gleicher Amplitude des Phasenkodiergradienten nur derjenige Scan verwendet wird, bei dem die zugehörige Amplitude der Atembewegung das vorgegebene Kriterium bezüglich des Referenzwertes erfüllt.

2. Verfahren nach Anspruch 1, **dadurch gekennzeichnet,** daß das Kriterium eine minimale Differenz zwischen der Amplitude der Atembewegung und dem Referenzwert ist.

3. Verfahren nach einem der Ansprüche 1 oder 2, **dadurch gekennzeichnet,** daß zusätzlich zur Amplitude der Atembewegung deren Steigung zum Scanzeitpunkt abgespeichert wird.

4. Verfahren nach Anspruch 3, **dadurch gekennzeichnet,** daß das Kriterium das Vorzeichen der Steigung umfaßt.

5. Verfahren nach einem der Ansprüche 1 bis 4, **dadurch gekennzeichnet,** daß die Scans innerhalb des Atemzyklus jeweils in der gleichen Herzschlagphasenlage getriggert werden.

6. Verfahren nach einem der Ansprüche 1 bis 5, **dadurch gekennzeichnet,** daß es bei einer vorgegebenen Anzahl von Fourierzeilen angewendet wird, die im mittleren Bereich der Meßmatrix liegen.

7. Verfahren nach Anspruch 6, **dadurch gekennzeichnet**, daß das MR-Bild aus 256 Fourierzeilen zusammengesetzt wird, und das Verfahren im mittleren Bereich bei der 108. bis 148. Fourierzeile angewendet wird.

8. Verfahren nach einem der Ansprüche 1 bis 6, **dadurch gekennzeichnet**, daß der Referenzwert der Wert ist, bei welchem die Standardabweichung der Amplituden der Atembewegung bei einer vorgegebenen Anzahl von mittleren Fourierzeilen am kleinsten ist.

9. Verfahren nach Anspruch 8, **dadurch gekennzeichnet**, daß die Anzahl der Fourierzeilen 7 ist, und daß die 7 Fourierzeilen im mittleren Bereich der Meßmatrix liegen.

10. Verfahren nach einem der Ansprüche 1 bis 9, **dadurch gekennzeichnet**, daß zusätzlich zur Amplitude der Atembewegung der Scanzeitpunkt in dem zweiten Speicher (51) abgespeichert wird.

11. Verfahren nach einem der Ansprüche 1 bis 10, **dadurch gekennzeichnet**, daß der Phasenkodiergradient des MR-Gerätes in Abhängigkeit einer Bewegungsphase der Atembewegung weitergeschaltet wird.

12. Verfahren nach einem der Ansprüche 1 bis 11, **dadurch gekennzeichnet**, daß der Phasenkodiergradient einmal pro Atemzyklus weitergeschaltet wird.

13. Vorrichtung zur Durchführung des Verfahrens nach Anspruch 1 mit einem Atemdetektor zur Erfassung der Atembewegung, mit von einer Steuervorrichtung gesteuerten Gradientenspulen zur Erzeugung des Phasenkodiergradienten und mit einem Sichtgerät zur Darstellung des MR-Bildes, **gekennzeichnet durch** einen ersten Speicher (53), der zur Abspeicherung der Werte der gemessenen Spinechos vorgesehen ist, durch einen zweiten Speicher (47), der zur Abspreicherung der Amplitude der Atembewegung zum zugehörigen Scanzeitpunkt vorgesehen ist, durch einen Vergleicher (57), in welchem die Amplituden der Atembewegung zu den Scanzeitpunkten mit einem vorgegebenen Referenzwert vergleichbar sind, und durch ein Steuergerät (58), welches nur diejenigen Spinechosignale eines einzigen Scans pro Amplitudenstellung des Phasenkodiergradienten zur MR-Bilddarstellung freigibt, bei dem die zugeordnete Amplitude der Atembewegung ein in dem Vergleicher (57) einstellbares Kriterium bezüglich des Referenzwertes erfüllt.

14. Vorrichtung nach Anspruch 13, **dadurch gekennzeichnet**, daß der Vergleicher (57) ein Einstellglied (59) aufweist, an dem der Referenzwert vorgebbar ist.

15. Vorrichtung nach Anspruch 13, **dadurch gekennzeichnet**, daß der Vergleicher (57) eine Referenzwertschaltung enthält, mit welcher von allen Scans mehrerer mittlerer Fourierzeilen die Amplituden mit der geringsten Standardabweichung ermittelbar sind.

**Claims**

1. A method for composing a magnetic resonance image using a measuring matrix formed of individual Fourier rows with a respiration-controlled recording of the spin echoes, which are received by a magnetic resonance apparatus, wherein a respiratory cycle is examined to see whether it fulfils a criterion in respect of a given reference value and wherein during each respiratory cycle a plurality of scans are recorded, each scan being defined by the excitation of the nuclear spin and a subsequent scanning of the read-out nuclear resonance signal, characterised in that corresponding to the number of respiration-controlled recorded Fourier rows, the phase code gradient of the magnetic resonance device is incremented once per respiratory cycle at the most, in that the spin echoes recorded with each scan are stored in a first store, in that the amplitude of the respiratory movement at the respective scanning time is stored in a second store, in that a comparison of all the stored amplitudes of the respiratory movement with the given reference value is carried out and in that for composing the magnetic resonance image with the same amplitude as the phase code gradient, only that scan is used in which the associated amplitude of the respiratory movement fulfils the given criterion in respect of the reference value.

2. A method according to claim 1, characterised in that the criterion is a minimal difference between the amplitude of the respiratory movement and the reference value.

3. A method according to one of claims 1 or 2, characterised in that the gradient of the respiratory movement at the scanning time is stored in addition to its amplitude.

4. A method according to claim 3, characterised in that the criterion includes the plus or minus sign of the gradient.

5. A method according to one of claims 1 to 4, characterised in that the scans are each respectively triggered at the same heartbeat phase position within the respiratory cycle.

6. A method according to one of claims 1 to 5, characterised in that it is used with a given number of Fourier rows which lie in the central region of the measuring matrix.

7. A method according to claim 6, characterised in that the magnetic resonance image is formed from 256 Fourier rows and the method is used in the central region with the 108th to 148th Fourier rows.

8. A method according to one of claims 1 to 6, characterised in that the reference value is a value wherein the standard deviation of the amplitudes of the respiratory movement over a given number of central Fourier rows is a minimum.

9. A method according to claim 8, characterised in that the number of Fourier rows is 7 and the 7 Fourier rows lie in the central region of the measuring matrix.

10. A method according to one of claims 1 to 9, characterised in that the scanning time is stored in the second store (51) in addition to the amplitude of the respiratory movement.

11. A method according to one of claims 1 to 10, characterised in that the phase code gradient of the magnetic resonance image is incremented as a function of the movement phase of the respiratory movement.

12. A method according to one of claims 1 to 11, characterised in that the phase code gradient is incremented once per respiratory cycle.

13. A device for carrying out the method according to claim 1, with a respiration detector for determining the respiratory movement, with gradient coils controlled by a control device for producing the phase code gradients and with a display device for displaying the magnetic resonance image, characterised by a first store (53), which is provided for storing the values of the measured spin echoes, by a second store (47), which is provided for storing the amplitude of the respiratory movement at the associated scanning time, by a comparator (57), in which the amplitudes of the respiratory movement at the scanning times can be compared with a given reference value, and by a control device (58), which only releases those spin echo signals of a single scan per amplitude position of the phase code gradient for the magnetic resonance image display in which the associated amplitude of the respiratory movement fulfils a criterion which can be set in the comparator (57) in respect of a reference value.

14. A device according to claim 13, characterised in that the comparator (57) comprises an adjusting member (59) at which the reference value can be preset.

15. A device according to claim 13, characterised in that the comparator (57) comprises a reference value circuit, by means of which the amplitudes having the smallest standard deviation can be detected from all the scans of a plurality of central Fourier rows.

## Revendications

1. Procédé pour composer une image obtenue par résonance magnétique à partir d'une matrice de mesure constituée par des lignes individuelles de Fourier, au moyen d'un enregistrement, commandé par la respiration, des échos de spins qui sont reçus par un appareil à résonance magnétique, et selon lequel le cycle respiratoire est examiné pour voir s'il satisfait à un critère relatif à une valeur de référence prédéterminée et selon lequel, pendant chaque cycle respiratoire, une multiplicité de balayages sont enregistrés, chaque balayage étant défini par l'excitation des spins nucléaires et par une exploration ultérieure du signal de résonance nucléaire lu, caractérisé par le fait que le gradient de codage de phase de l'appareil à résonance magnétique est incrémenté au maximum une fois lors de chaque cycle respiratoire, en fonction du nombre des lignes de Fourier enregistrées et commandées en fonction de la respiration, que les échos de spins enregistrés pour chaque balayage, sont mémorisés dans une première mémoire, que l'amplitude du mouvement respiratoire est mémorisée pour l'instant respectif de balayage dans une seconde mémoire, qu'une comparaison entre toutes les amplitudes mémorisées du mouvement respiratoire et la valeur de référence prédéterminée est exécutée et que, pour la composition de l'image obtenue par résonance magnétique pour une amplitude identique du gradient de codage de phase, seul est utilisé le balayage, lors duquel l'amplitude associée du mouvement respiratoire satisfait au caractère prédéterminé concernant la valeur de référence.

2. Procédé suivant la revendication 1, caractérisé par le fait que le critère est une différence minimale entre l'amplitude du mouvement respiratoire et la valeur de référence.

3. Procédé suivant l'une des revendications 1 ou 2, caractérisé par le fait qu'en plus de l'amplitude du mouvement respiratoire, sa pente à l'instant de balayage est mémorisée.

4. Procédé suivant la revendication 3, caractérisé par le fait que le critère inclut le signe de la pente.

5. Procédé suivant l'une des revendications 1 à 4, caractérisé par le fait que les balayages au cours d'un cycle respiratoire sont déclenchés respectivement dans la même position de phase du battement cardiaque.

6. Procédé selon l'une des revendications 1 à 5, caractérisé en ce qu'on le met en œuvre dans le cas d'un nombre prédéterminé de lignes de Fourier qui sont situées dans la zone centrale de la matrice de mesure.

7. Procédé suivant la revendication 6, caractérisé par le fait que l'image obtenue par résonance magnétique se compose de 256 lignes de Fourier, et que le procédé est mis en œuvre dans la zone centrale pour les 108-ème à 148-ème lignes de Fourier.

8. Procédé suivant l'une des revendications 1 à 6, caractérisé par le fait que la valeur de référence est la valeur pour laquelle l'écart-type des amplitudes du mouvement respiratoire est la plus faible pour un nombre prédéterminé de lignes centrales de Fourier.

9. Procédé suivant la revendication 8, caractérisé par le fait que le nombre des lignes de Fourier est égal à 7 et que les 7 lignes de Fourier sont situées dans la zone centrale de la matrice de mesure.

10. Procédé suivant l'une des revendications 1 à 9, caractérisé par le fait qu'en plus de l'amplitude du mouvement respiratoire, l'instant de balayage est mémorisé dans la seconde mémoire (51).

11. Procédé suivant l'une des revendications 1 à 10, caractérisé par le fait que le gradient de codage de phase de l'appareil à résonance magnétique est incrémenté en fonction d'une phase de déplacement du mouvement respiratoire.

12. Procédé suivant l'une des revendications 1 à 11, caractérisé par le fait que le gradient de codage de phase est incrémenté une fois lors de chaque cycle respiratoire.

13. Dispositif pour la mise en œuvre du procédé suivant la revendication 1, comportant un détecteur de la respiration servant à détecter le mouvement respiratoire, des bobines de gradient commandées par un dispositif de commande et servant à produire le gradient de codage de phase et un appareil de visualisation servant à représenter l'image obtenue par résonance magnétique, caractérisé par une première mémoire (53) prévue pour mémoriser les

valeurs des échos de spins mesurés, une seconde mémoire (47), prévue pour mémoriser l'amplitude du mouvement respiratoire à l'instant associé de balayage, un comparateur (57), dans lequel les amplitudes du mouvement respiratoire aux instants de balayage sont comparables à une valeur de référence prédéterminée, et un appareil de commande (58), qui libère, pour la formation de l'image par résonance magnétique, uniquement les signaux d'échos de spins d'un seul balayage pour chaque position d'amplitude du gradient de codage de phase, pour lequel l'amplitude associée du mouvement respiratoire satisfait à un critère concernant la valeur de référence et réglable dans le comparateur (57).

14. Dispositif suivant la revendication 13, caractérisé par le fait que le comparateur (57) possède un circuit de réglage (59), dans lequel la valeur de référence peut être préréglée.

15. Dispositif selon la revendication 13, caractérisé en ce que le comparateur (57) contient un circuit à valeur de référence, à l'aide duquel les amplitudes possédant l'écart-type minimum peuvent être déterminées à partir de l'ensemble des balayages de plusieurs lignes centrales de Fourier.

FIG 1

FIG 2

24 2

25 f

FIG 3

29

27

| 1 | 1 | 2 | 3 | 4 | 5 | 6 | 7 | 8 | 9 | 10 | 11 | 12 |
|---|---|---|---|---|---|---|---|---|---|----|----|----|
| 2 | 13 | | | | | | | | | | | 24 |
| 3 | 25 | | | | | | | | | | | 36 |
| 4 | 37 | | | | | | | | | | | 48 |
| 5 | 49 | | | | | | | | | | | 60 |
| 6 | 61 | | | | | | | | | | | 72 |
| 255 | | | | | | | | | | | | 3060 |
| 256 | 3061 | | | | | | | | | | | 3072 |

54

FIG 4

FIG 5

EP 0 200 049 B1